# EUROPÄISCHE PATENTSCHRIFT

(11) **EP 0 758 282 B1**
(45) Veröffentlichungstag und Bekanntmachung des Hinweises auf die Patenterteilung: **06.02.2002**
(21) Anmeldenummer: 95915115.0
(22) Anmeldetag: 22.03.1995
(51) Int. Cl.: B23K 3/08

(54) **VERFAHREN ZUM WELLENLÖTEN VON LEITERPLATTEN**
PROCESS FOR WAVE-SOLDERING PRINTED CIRCUIT BOARDS
PROCEDE DE BRASAGE A LA VAGUE DE CARTES A CIRCUIT IMPRIME

(30) Priorität: 06.05.1994 DE 4416788
(43) Veröffentlichungstag der Anmeldung: 19.02.1997
(73) Patentinhaber: SIEMENS AKTIENGESELLSCHAFT, 80333 München (DE)
(72) Erfinder: ALBRECHT, Hans-Jürgen, D-13051 Berlin (DE); STRICK, Günter-Werner, D-10719 Berlin (DE)
(86) Internationale Anmeldenummer: DE9500441
(87) Internationale Veröffentlichungsnummer: WO9530509

(56) Entgegenhaltungen:
- EP-A- 0 365 977
- DE-C- 3 611 180
- DE-C- 3 843 191

## Beschreibung

Die Erfindung bezieht sich auf ein Verfahren zum Wellenlöten von Leiterplatten, bei dem die Leiterplatten nach dem Durchlaufen der Lotwelle künstlich abgekühlt werden.

Ein Verfahren dieser Art läßt sich der deutschen Patentschrift DE 36 11 180 C1 entnehmen, in der eine Vorrichtung zum Kühlen von Lötwerkstückträgern und Lötgut bei Lötanlagen mittels Kühlluftzufuhr beschrieben ist. Bei dem bekannten Verfahren werden die Leiterplatten nach dem Durchlaufen der Lotwelle auf ihrer Unterseite mit Luft aus Düsen gekühlt, die beidseitig des Transportweges angeordnet sind. Dadurch wird eine gleitende und auch rasche Abkühlung erreicht, so daß bei einer nachfolgenden Reinigung kaum noch Reinigungsmittel verdunstet; auch Flußmittelrückstände verdunsten so gut wie gar nicht mehr.

Es ist ferner allgemein bei mit dem Wellenlöten von Leiterplatten befaßten Fachleuten bekannt, daß sich beim Löten auf den Leiterplatten Lotkügelchen festsetzen, die unerwünscht sind, weil sie bei mit derartigen Leiterplatten bestückten elektrischen oder elektronischen Geräten zu schweren Funktionsstörungen führen können.

Man hat deshalb bereits versucht, schon beim Wellenlöten von Leiterplatten selbst die Bildung von Lotkügelchen dadurch zu vermeiden, daß man spezielle Lötstoplacke eingesetzt hat; die Modifizierung von Lötstoplacken im Hinblick auf die Vermeidung von Lotkügelchen auf Leiterplatten ist aber nur begrenzt möglich, weil die Lötstoplacke die Fähigkeit behalten müssen, adhäsiv auf den Kupfer-Überzügen der Leiterplatte zu haften. Deshalb ist es nicht möglich, Lötscoplacke herzustellen, die eine Adhäsion von Lot vollkommen vermeiden.

Man muß deshalb derzeit in Kauf nehmen, daß sich beim Wellenlöten von Leiterplatten Lotkügelchen auf den Leiterplatten festsetzen. Da diese Lotkügelchen aber auf den Leiterplatten beim Zusammenbau zu einem elektrischen oder elektronischen Gerat nicht verbleiben dürfen, erfolgt in einem dem Wellenlöten nachgeordneten Fertigungsgang ein mechanisches Abbürsten der Leiterplatten auf der Lötseite. Dazu bedarf es definierter Bürstenanordnungen mit bestimmten Bürstenmaterialien, um einerseits mit Sicherheit die adhäsiv fixierten Lotkügelchen auf den Leiterplatten vom Lötstoplack zu entfernen und um andererseits Beschädigungen an den Leiterplatten bei diesem Arbeitsgang zu vermeiden. Anschließend sind die gebürsteten Leiterplatten einer Inaugenscheinnahme zu unterwerfen um sicherzustellen, daß letztendlich nur lotkügelchenfreie Leiterplatten weiter verwendet werden.

Der Erfindung liegt die Aufgabe zugrunde, ein Verfahren zum Wellenlöten von Leiterplatten vorzuschlagen, mit dem sich lotkügelchenfreie Leiterplatten herstellen lassen.

Zur Lösung dieser Aufgabe erfolgt bei einem Verfahren der eingangs angegebenen Art erfindungsgemäß die Abkühlung der jeweiligen Leiterplatte auf Raumtemperatur unter Erzielung einer unterschiedlichen Kontraktion einer auf der Leiterplatte üblicherweise befindlichen Lötstoppmaske und des auf der Leiterplatte aufgebrachten Lotes mit einem annähernd gleichbleibenden Temperaturgradienten von etwa 20 °K/s. Bei dem erfindungsgemäßen Verfahren werden die wellengelöteten Leiterplatten also nach Durchlaufen der Lotwelle künstlich mit dem angegebenen Temperaturgradienten abgekühlt, wodurch die Haftung von Lotkügelchen auf der Lotseite der Leiterplatten verhindert wird.

Der Erfindung liegt das Erkennen folgender Zusammenhänge zugrunde:

Beim Wellenlöten insbesondere gemischt bestückter Leiterplatten, also von Leiterplatten, die mit SMD-Bauteilen (Surface Mounted Devices) und mit Anschlußdrähten versehenen Bauteilen bestückt sind, wird die Lotwelle in ihrem Strömungsverhalten wesentlich durch die Bauteile bzw. ihre Anschlüsse gestört. Dies führt dazu, daß die homogene Lotwelle durch die Strömungsbehinderungen beim Durchlaufen der Leiterplatten separiert wird. Die dadurch entstehenden separierten Lotvolumina sind nunmehr besonders stark der oxidierenden Lötatmosphäre ausgesetzt. Es entstehen Zinn-Blei-Mischoxyde, die Feststoffe darstellen und die einzelnen separierten Lotvolumina bedecken. Sie sind durch die Reduzierung der Oberflächenspannung besonders geeignet, auf der Lötstoppmaske der Leiterplatten als Lotkügelchen adhäsiv fixiert zu werden. Die Lötstopplacke bestehen unter anderem aus anorganischen Füllstoffen mit polaren Eigenschaften und weisen Oberflächenspannungen auf, die in der Nähe der Oberflächenspannungen von Zinn-Blei-Oxyden liegen. Deshalb entstehen an den Grenzflächen zwischen dem Lötstopplack und dem Zinn-Blei-Oxyden relativ starke Adhäsionskräfte, die zur Haftung der Lotkügelchen führen.

Die nach dem Durchlaufen der Lotwelle durch die Strömungsbehinderungen separierten Lotvolumina befinden sich thermisch auf dem Niveau der Lotwelle und bilden oxidierte flüssige Zinn-Blei-Partikel mit sphärischer Form. Der thermische Energieeintrag beim Wellenlöten bewirkt nun nicht nur die Verbindung zwischen dem Lot und den miteinander zu verlötenden Teilen der Leitungsplatte, sondern führt auch zu einer wesentlichen dreidimensionalen Änderung der Lötstoppmaske auf den Leiterplatten. Die Ausdehnung der Lötstoppmaske beträgt in einem unteren Temperaturbereich etwa 60 bis 80 ppm/°K und ist im Bereich der Lotwellentemperatur erheblich größer; die Ausdehnung von Sn60Pb40-Lot beträgt dagegen 23 ppm/°K. Die Erfindung nutzt nun die unterschiedlichen Temperaturausdehnungen der Lötstoppmaske und des Zinn-Blei-Lotes aus, indem durch eine zusätzliche künstliche Abkühlung die Adhäsionsflächen zwischen dem Lötstopplack und dem Lot verringert werden. Dabei wird die unterschiedliche Kontraktion der Lötstoppmaske und des Lotes ausgenutzt, um die beim Durchlaufen der Lotwelle gebildeten Adhäsionsflächen zwischen Lötstoppmaske und Lot reversibel zu stören; es wird also bewußt eine thermomechanische Fehlanpassung zwischen Lötstoppmaske und Lot durch die zusätzliche künstliche Abkühlung erzeugt, um Adhäsionskräfte abzubauen.

Bei dem erfindungsgemäßen Verfahren kann die zusätzliche künstliche Abkühlung der Leiterplatten nach dem Durchlaufen der Lotwelle in unterschiedlicher Weise erfolgen, beispielsweise mit einer Kühlkammer, die die wellengelöteten Leiterplatten durchlaufen. Fertigungstechnisch besonders einfach und mit relativ geringem Aufwand läßt sich das Verfahren nach der Erfindung jedoch dann durchführen, wenn auf den Bereich der Zone des Abreißens der Lotwelle von der jeweiligen Leiterplatte ein Gasstrom mit einer Temperatur gerichtet wird, die eine Abkühlung mit dem Temperaturgradienten von etwa 20 °K/s bewirkt.

Es ist zwar bereits aus der deutschen Offenlegungsschrift DE 28 52 132 A1 nach dem Aufbringen des Lotes auf die Leiterplatte ein Gasstrom gegen die Unterseite der jeweiligen Leiterplatte gerichtet wird, der Luft oder ein Schutzgas enthalten kann, jedoch soll hier durch den Gasstrom die Bildung von Lotkurzschlüssen, Lotbärten und Lotbrücken verhindert werden. Um dies bei dem bekannten Verfahren in zufriedenstellender Weise zu erreichen, werden unter anderem Strömungsgeschwindigkeit, Druck und Temperatur der Gasströmung den jeweiligen Gegebenheiten, wie unter anderem der Größe und der Packungsdichte auf der Leiterplatte angepaßt. Da bei dem bekannten Verfahren das überschüssige Lot weggeblasen wird, bevor das Lot erstarrt ist, wird bevorzugt eine Gasströmung mit vorgewärmter Luft benutzt; es ist aber auch an die Verwendung eines Gases mit Umgebungstemperatur gedacht.

Ferner ist es aus dem Buch von R.J. Klein-Wassink "Weichlöten in der Elektronik", 1991, Seiten 508 bis 510 bekannt, auf eine wellengelötete Leiterplatte unmittelbar nach dem Wellenlöten einen Gasstrom zu richten. Hierbei handelt es sich um einen Heißluftstrom, der dazu dient, unerwünschte Lotbrücken zwischen Leiterbahnen zu entfernen, um gute Lotstellen zu erhalten. Allerdings verursacht dieser Heißluftstrom zusätzliche Lotkügelchen, die durch Waschen nach dem Löten entfernt werden müssen.

Besonders gute Arbeitsergebnisse lassen sich mit dem erfindungsgemäßen Verfahren dann erzielen, wenn als Gas für den Gasstrom ein Schutzgas verwendet wird, bei dem es sich bevorzugt um Stickstoff handeln kann. Durch das Schutzgas wird im Austrittsbereich der Leiterplatte aus der Lotwelle eine weitgehend oxidationsfreie Atmosphäre geschaffen, die die oben angesprochene Oxydation von Zinn-Blei-Partikeln infolge der Separierung vermindert, wodurch die Lothaftung auf dem Lötstopplack unterstützend vermindert wird.

Zwar ist es aus dem oben bereits erwähnten Buch von Klein-Wassink, Seite 508 auch bekannt, Wellenlöten unter Schutzgasatmosphäre mit sehr geringen Sauerstoffanteilen durchzuführen, jedoch erfolgt hier das gesamte Wellenlöten unter Schutzgasatmosphäre und eine zusätzliche künstliche Abkühlung wird nicht vorgenommen. Dies führt zum Entstehen von verhältnismäßig vielen Lotkügelchen.

Zur Erläuterung der Erfindung ist in
- Figur 1: eine Draufsicht auf den im Zusammenhang mit der Erfindung interessierenden Teil einer Lötanlage zur Durchführung des erfindungsgemäßen Verfahrens und in
- Figur 2: eine Seitenansicht auf einen Ausschnitt aus der Figur 1 wiedergegeben.

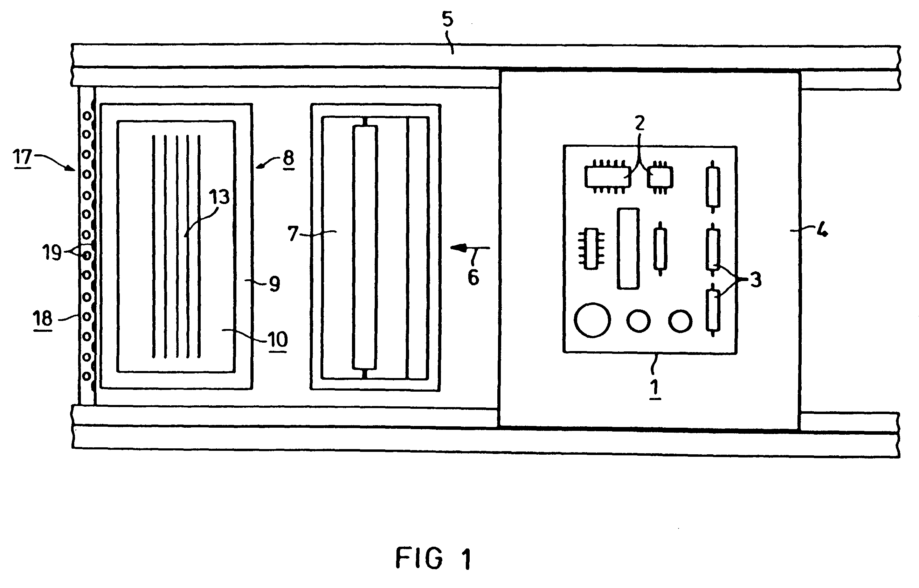

Wie der Figur 1 zu entnehmen ist, befindet sich eine zu lötende Leiterplatte 1 mit SMD-Bauteilen 2 sowie Bauteilen 3 mit Anschlußdrähten in einem Transportrahmen 4, der auf einer Transporteinrichtung 5 in Richtung des Pfeiles bewegt wer-

Zwar ist es aus dem oben bereits erwähnten Buch von Klein-Wassink, Seite 508 auch bekannt, Wellenlöten unter Schutzgasatmosphäre mit sehr geringen Sauerstoffanteilen durchzuführen, jedoch erfolgt hier das gesamte Wellenlöten unter Schutzgasatmosphäre und eine zusätzliche künstliche Abkühlung wird nicht vorgenommen. Dies führt zum Entstehen von verhältnismäßig vielen Lotkügelchen.

Das erfindungsgemäße Verfahren kann in Lötanlagen unterschiedlicher Ausführung durchgeführt werden. Als besonders vorteilhaft wird es im Hinblick auf die Herstellungskosten einer Lötanlage zur Durchführung des erfindungsgemäßen Verfahrens angesehen, wenn in Transportrichtung der Leiterplatte hinter der Lotwelle eine zusätzliche Kühleinrichtung für die Leiterplatten angeordnet ist. Diese Kühleinrichtung kann unterschiedlich ausgestaltet sein.

Als besonders vorteilhaft wird es im Hinblick auf die Herstellungskosten angesehen, wenn die Kühleinrichtung eine sich quer zur Transportrichtung der Leiterplatten erstreckende stabförmige Düse ist, von der der Gasstrom auf die jeweilige Leiterplatte nach dem Durchlaufen der Lotwelle gerichtet wird.

Zur Erläuterung der Erfindung ist in
- Figur 1: eine Draufsicht auf den im Zusammenhang mit der Erfindung interessierenden Teil einer Lötanlage zur Durchführung des erfindungsgemäßen Verfahrens und in

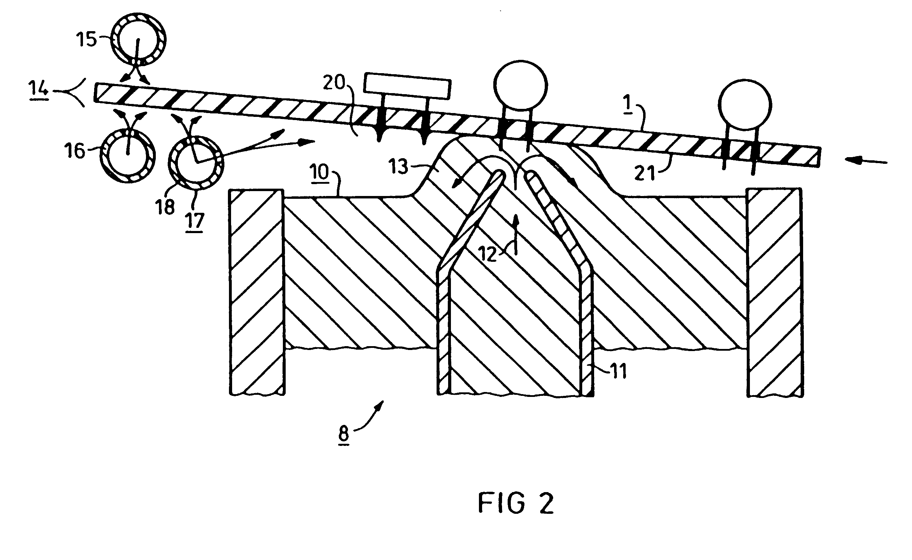

- Figur 2: eine Seitenansicht auf einen Ausschnitt aus der Figur 1 wiedergegeben.

Wie der Figur 1 zu entnehmen ist, befindet sich eine zu lötende Leiterplatte 1 mit SMD-Bauteilen 2 sowie Bauteilen 3 mit Anschlußdrahten in einem Transportrahmen 4, der auf einer Transporteinrichtung 5 in Richtung des Pfeiles 6 bewegt werden kann. In der dargestellten Stellung befindet sich der Transportrahmen dicht vor einer Benetzungseinrichtung 7, in der beim Darüberhinweglaufen der Leiterplatte 1 Flußmittel auf die in der Figur 1 untere Lötseite der Leiterplatte 1 aufgebracht wird.

Bevor die Leiterplatte in den Transportrahmen 4 eingelegt wird, ist sie nicht nur mit den Bauteilen 2 und 3 bestückt, sondern üblicherweise mit Kupfer-Leiterbahnen versehen und mit einem Lötstopplack auf in der Figur 1 unteren Seite an den Stellen bedeckt, an denen kein Lot an der Leiterplatte 1 bzw. an den Bauteilen 2 und 3 haften soll.

Nachdem der Transportrahmen 4 mit der zu lötenden Leiterplatte 1 über die Benetzungseinrichtung 7 hinweggelaufen ist, gelangt er in den Bereich einer Löteinrichtung 8, die in einem in der Figur 1 nur schematisch dargestellten Behälter 9 flüssiges Zinn-Blei-Lot 10 enthält. Dieses Lot wird - wie Figur 2 deutlicher erkennen läßt - mittels einer nicht dargestellten Pumpe in einem Förderkanal 11 in Richtung des Pfeiles 12 nach oben gepumpt und bildet somit eine Lotwelle 13. Die Transporteinrichtung 5 ist bezüglich der Lotwelle 13 so ausgerichtet, daß die zu lötende Leiterplatte 1 - wie wiederum Figur 2 deutlich zeigt - die Welle 13 durchläuft, wodurch das Löten erfolgt.

In Transportrichtung (Pfeil 6) hinter der Löteinrichtung 8 befindet sich außer einer ersten Kühleinrichtung 14 mit Düsen 15 und 16 eine zusätzliche Kühleinrichtung 17, die in den Figuren 1 und 2 ebenfalls nur schematisch dargestellt ist. Im wesentlichen enthält die zusätzliche Kühleinrichtung 17 eine stabförmige Düse 18, die mit einzelnen Austrittsöffnungen 19 für einen Schutzgasstrom versehen ist. Die Ausrichtung der Düse 18 bzw. ihrer Öffnungen ist dabei derart, daß das Schutzgas, vorzugsweise Stickstoff, in den Bereich 20 hinter der Lotwelle 13 gegen die Leiterplatte 1 geblasen wird. Der Stickstoff hat eine Temperatur von höchstens der Raumtemperatur, so daß durch den Gasstrom eine zusätzliche künstliche Abkühlung der Leiterplatte 1 nach dem Durchlaufen der Lotwelle 13 erfolgt. Bei einer Abkühlung mit einem zeitlichen Temperaturgradienten von etwa 20 °K/s werden Leiterplatten hergestellt, die so gut wie keine Lotkügelchen mehr auf der Lötseite 21 aufweisen.

Die stabförmige Düse 18 kann um ihre Längsachse drehbar angeordnet sein, um die zusätzliche Abkühlung unterschiedlichen Wärmekapazitäten der Leiterplatten anpassen zu können.

## Patentansprüche

1. Verfahren zum Wellenlöten von Leiterplatten, bei dem die Leiterplatten (1) nach dem Durchlaufen der Lotwelle (13) künstlich abgekühlt werden,
**dadurch gekennzeichnet,**
**daß** die Abkühlung der jeweiligen Leiterplatte (1) auf Raumtemperatur unter Erzielung einer unterschiedlichen Kontraktion einer auf der Leiterplatte üblicherweise befindlichen Lötstoppmaske und des auf der Leiterplatte aufgebrachten Lotes mit einem annähernd gleichbleibenden Temperaturgradienten von etwa 20 °K/s erfolgt.

2. Verfahren nach Anspruch 1,
bei dem auf den aus der Lotwelle (13) ausgetretenen Bereich (17) der jeweiligen Leiterplatte (1) ein Gasstrom mit einer derartigen Temperatur gerichtet wird, daß eine Abkühlung mit dem annähernd gleichbleibenden Temperaturgradienten von 20°K/s erfolgt.

3. Verfahren nach Anspruch 2,
bei dem als Gas ein Schutzgas verwendet wird.

4. Verfahren nach Anspruch 3,
bei dem Stickstoff als Schutzgas verwendet wird.

## Claims

1. Process for wave-soldering printed circuit boards, in which, after passing through the solder wave, the printed circuit boards are artificially cooled,
**characterised in that**
the cooling of the respective printed circuit board (1) takes place at room temperature while achieving a different contraction between a solder resist mask usually located on the printed circuit board, and the solder deposited on the printed circuit board, with an approximately constant temperature gradient of around 20 °K/s.

2. Process according to Claim 1,
in which a gas stream is directed at such a temperature on the area (17) of the respective printed circuit board (1) exiting the solder wave (13), that cooling is achieved with the approximately constant temperature gradient of 20 °K/s.

3. Process according to Claim 2,
in which an inert gas is used as the gas.

4. Process according to Claim 3,
in which nitrogen is used as the inert gas.

## Revendications

1. Procédé pour le soudage à la vague de cartes imprimées, dans lequel les cartes imprimées (1) sont, après passage de la vague (13), artificiellement refroidies, **caractérisé en ce que** le refroidissement de la carte imprimée (1) considérée a lieu jusqu'à la température ambiante, en réalisant une différence de contraction entre une réserve de soudure se trouvant habituellement sur la carte imprimée et le métal d'apport appliqué sur la carte imprimée, avec un gradient de température approximativement constant d'environ 20°K/s.

2. Procédé selon la revendication 1, dans lequel on envoie sur la zone (17), sortant de la vague de soudage (13), de la carte imprimée considérée (1), un courant de gaz à une température telle qu'il en résulte un refroidissement selon un gradient de température approximativement constant de 20 K/s.

3. Procédé selon la revendication 2, dans lequel on utilise en tant que gaz un gaz protecteur.

4. Procédé selon la revendication 3, dans lequel on utilise de l'azote en tant que gaz protecteur.
